(19) **Europäisches Patentamt / European Patent Office / Office européen des brevets**

(11) **EP 2 353 347 B1**

(12) **FASCICULE DE BREVET EUROPEEN**

| | |
|---|---|
| (45) Date de publication et mention de la délivrance du brevet: **27.07.2016 Bulletin 2016/30** | (51) Int Cl.: ***H05H 1/46*** *(2006.01)* ***H01J 37/32*** *(2006.01)* |
| (21) Numéro de dépôt: **09740707.6** | (86) Numéro de dépôt international: **PCT/EP2009/064231** |
| (22) Date de dépôt: **28.10.2009** | (87) Numéro de publication internationale: **WO 2010/049456 (06.05.2010 Gazette 2010/18)** |

(54) **DISPOSITIF ET PROCEDE DE PRODUCTION ET/OU DE CONFINEMENT D'UN PLASMA**

EINRICHTUNG UND VERFAHREN ZUM ERZEUGEN UND/ODER EINGRENZEN EINES PLASMAS

DEVICE AND METHOD FOR PRODUCING AND/OR CONFINING A PLASMA

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **30.10.2008 FR 0857392**

(43) Date de publication de la demande:
**10.08.2011 Bulletin 2011/32**

(73) Titulaires:
• **Centre National de la Recherche Scientifique (CNRS)**
**75016 Paris (FR)**
• **Université Joseph Fourier - Grenoble 1**
**38400 Saint-Martin-d'Hères (FR)**

(72) Inventeurs:
• **PELLETIER, Jacques**
**F-38400 Saint Martin d'Heres (FR)**
• **BECHU, Stéphane**
**F-38470 Chantesse (FR)**
• **BES, Alexandre**
**F-38210 Vourey (FR)**
• **LACOSTE, Ana**
**F-38950 Saint Martin le Vinoux (FR)**

(74) Mandataire: **Regimbeau**
**20, rue de Chazelles**
**75847 Paris Cedex 17 (FR)**

(56) Documents cités:
**WO-A-2008/009558    WO-A-2008/009559**

**Description**

DOMAINE GENERAL DE L'INVENTION

L'invention concerne un dispositif de production et/ou de confinement d'un plasma, comportant une enceinte dans le volume de laquelle le plasma est produit ou confiné, ladite enceinte comprenant une paroi définissant une enveloppe intérieure à l'enceinte et englobant le volume.

L'invention concerne également un procédé de production et/ou de confinement d'un plasma.

ETAT DE L'ART

Le confinement des plasmas dans un volume par des aimants permanents est utilisé depuis de nombreuses années de manière universelle, en raison de l'accroissement des performances qu'il permet en termes de densité et d'uniformité du plasma.

Depuis 1974, la technique n'a pas évolué, puisque le confinement du plasma est réalisé de manière générale en plaçant à la périphérie du volume de confinement, à l'intérieur ou à l'extérieur des parois de l'enceinte, des aimants permanents présentant au plasma dés polarités nord et sud alternées, d'où le nom de confinement magnétique multipolaire.

Dès 1975, une étude a été effectuée afin de déterminer le meilleur arrangement et la distance optimale entre aimants permanents. Cette étude a montré que c'était les structures continues en ligne, et non les structures en échiquier ou en ligne interrompue, qui procuraient le meilleur confinement. Par contre, la distance entre aimants, qui présente un maximum relativement plat, semble moins critique.

Enfin, en 1992, la meilleure connaissance des mécanismes de confinement magnétique multipolaire permit de proposer, pour améliorer l'efficacité du confinement, de refermer les structures magnétiques multipolaires sur elles-mêmes à la manière des structures "magnétron".

Le principe du confinement multipolaire du plasma, et en particulier des électrons qui produisent le plasma, semble désormais bien connu. En effet, les particules chargées qui rentrent dans la région d'influence d'un champ magnétique multipolaire :

1) soit sont réfléchies par ce champ magnétique et sont renvoyées dans la région exempte de champ magnétique d'où elles étaient issues (mécanisme que l'on appellera « mécanisme 1 »);
2) soit franchissent en totalité la région de champ magnétique dans les régions où leur trajectoire est presque parallèle aux lignes de champ magnétiques, puisqu'il n'y a pas alors couplage entre la particule chargée et le champ magnétique (mécanisme que l'on appellera « mécanisme 2 »). C'est le cas des particules chargées qui arrivent de la zone sans champ magnétique, soit directement vers le pôle des aimants, soit directement dans la zone de champ magnétique d'intensité nulle située entre deux aimants de même polarité (cas des aimants unitaires alternés);
3) soit sont piégées dans le champ magnétique multipolaire par mécanisme collisionnel (mécanisme que l'on appellera « mécanisme 3 »).

Autrement dit, les seules particules chargées qui sont perdues pour le plasma sont :

- d'une part celles qui sont piégées sur des lignes de champ (*mécanisme 3*) qui traversent des surfaces matérielles, et
- d'autre part celles qui arrivent depuis le volume exempt de champ magnétique vers les régions de convergence des lignes de champ magnétique (*mécanisme 2*), c'est-à-dire soit aux pôles magnétiques (intensité magnétique maximale), soit entre deux aimants de même polarité (intensité magnétique minimale nulle). Ces zones de convergence des lignes de champ magnétique sont appelées *"festons"* (ou "*cusps*" en anglais).

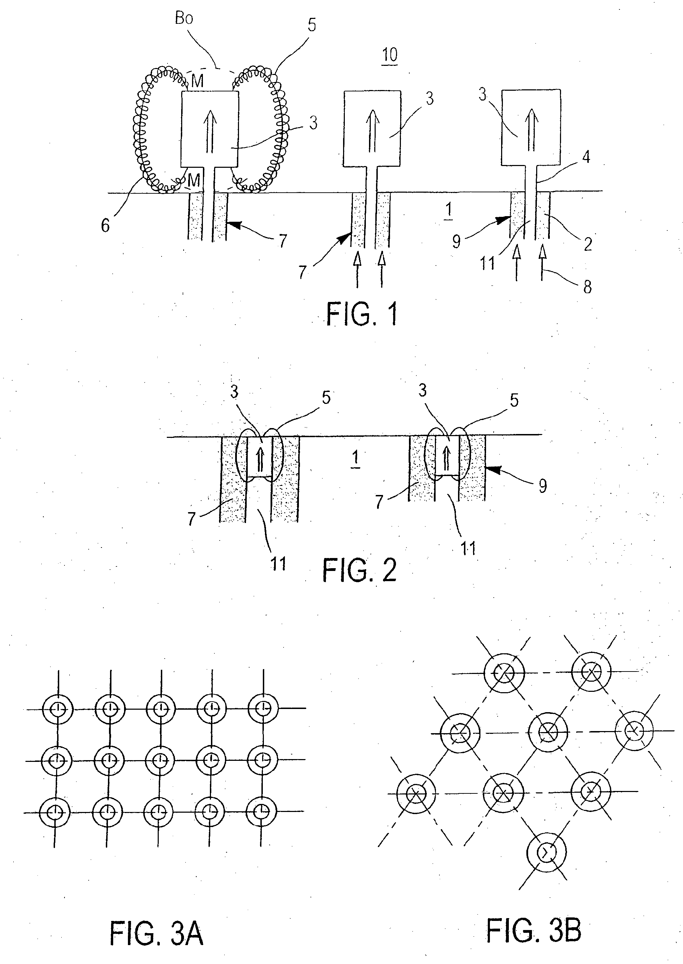

Les électrons énergiques qui produisent le plasma (dits électrons rapides ou primaires) sont peu sensibles au champ électrique auto-consistant produit par la charge d'espace du plasma. Une fois piégés dans le champ magnétique $B_0$, comme le montre la Fig. 1, dans l'intervalle entre deux collisions élastiques ou inélastiques, les électrons 6 oscillent entre deux points miroir M (où l'intensité du champ magnétique est identique). Les points miroir M sont situés face à deux pôles magnétiques opposés des aimants 3. Les électrons 6 oscillent entre les points M en s'enroulant autour d'une ligne de champ moyenne 5. Leurs trajectoires restent inscrites entre deux lignes de champ magnétique d'intensité constante.

Contrairement aux électrons rapides précités - peu sensibles au champ électrique du plasma comme on l'a dit - , les ions et les électrons peu énergiques du plasma (dits électrons lents ou thermiques), qui oscillent, eux aussi, entre deux pôles magnétiques opposés, sont eux sensibles au champ électrique du plasma et diffusent dans le champ magnétique de façon collective, sous l'influence de ce champ électrique.

Enfin, en dehors de ces mouvements d'oscillation et de diffusion, les particules chargées dérivent le long ou autour des aimants, perpendiculairement au plan qui contient le vecteur du champ magnétique généré par la structure magnétique. C'est pour cette raison qu'il est hautement préférable de refermer sur elles-mêmes les structures dé champ magnétique (structures de type magnétron, en anneau, en peigne ou en piste) afin d'éviter les pertes de particules chargées aux extrémités des structures magnétiques continues.

Dans les structures de confinement magnétique multipolaire, le plasma était produit à l'origine par des électrons émis par des filaments thermo-émissifs situés à l'intérieur de la structure de confinement et polarisés négativement par rapport à l'enceinte et à la structure magnétique.

En fait, le plasma peut aussi être produit dans l'enceinte ou à sa périphérie par tout moyen ou méthode appropriés. En fait, tout type d'excitation du plasma est envisageable, quelle que soit la fréquence d'excitation et le mode d'excitation (Résonance Cyclotronique Electronique (ou RCE), décharge continue, décharge continue pulsée, décharge basse fréquence BF, décharge radiofréquence RF, onde de surface, décharge inductive, décharge magnétron, etc.).

Il est même possible d'utiliser les structures magnétiques de confinement pour exciter le plasma, soit par application à la structure d'une tension négative continue ou continue pulsée, d'une tension BF ou RF, soit par l'application de micro-ondes pour une excitation de type résonance électronique cyclotronique distribuée (RCED).

Un des moyens pour confiner et produire des plasmas de grandes dimensions entretenus par champs HF, principalement dans la gamme des micro-ondes (typiquement au dessus de la centaine de MHz), est de distribuer des sources élémentaires selon des réseaux à deux ou trois dimensions.

Des sources de plasma micro-ondes distribuées selon un réseau bi-dimensionnel permettent de réaliser des sources planes (ou gauches de grandes dimensions), tandis que des sources distribuées selon un réseau tri-dimensionnel permettent, à titre d'exemples non limitatifs, de produire des volumes de plasma, par exemple dans un réacteur de géométrie cylindrique ou sphérique.

Des exemples de dispositifs sont divulgués dans FR 2 797 372, FR 2 838 020, et FR 2 840 451.

FR 2 797 372 et FR 2 838 020 divulguent des dispositifs permettant de produire, à basse pression (de $10^{-2}$ à quelques pascal), des plasmas plans ou cylindriques à partir de sources élémentaires entretenues par micro-ondes à la résonance cyclotronique électronique (RCE). La production du plasma par RCE requiert la présence d'un champ magnétique qui permet de définir des régions où la fréquence $f_0$ du champ électrique micro-onde appliqué est égale à la fréquence de giration des électrons dans le champ magnétique d'amplitude $B_0$, soit

$$f_0 = eB_0/2\pi m_e \qquad (1)$$

où $m_e$ est la masse de l'électron.

Dans FR 2 797 372 et FR 2 838 020, le champ magnétique est produit par un aimant permanent (dipôle magnétique) fixé à l'extrémité d'un applicateur micro-onde coaxial. Pour cette raison, ces types de plasma sont appelés plasmas multi-dipolaires. En particulier, et comme le montre la Fig. 1, FR 2 838 020 enseigne de disposer des aimants permanents 3 à distance des parois 1, grâce à des tiges 4, pour éviter que les trajectoires 6 des électrons ne coupent les parois 1 et donc qu'ils soient collectés sur ces surfaces.

La figure 1 montre que FR 2 838 020 propose une solution satisfaisante au niveau du confinement du plasma 10 puisque aucune ligne de champ 5 ne rencontre de surface ou une paroi 1, évitant ainsi des pertes directes d'électrons sur les parois.

Par contre, la production de plasma par RCE, telle que décrite dans FR 2 797 372 et FR 2 838 020, présente des inconvénients majeurs en fonction des conditions opératoires des sources élémentaires, à savoir :

1) le plasma 10 est produit préférentiellement sur la partie cylindrique autour de l'aimant 3, et non pas sur la face avant de l'aimant, comme c'est préférable dans de nombreuses applications ;

2) le domaine de pression de cette technique est limité aux basses pressions, typiquement au pascal (10 mtorr), car, aux pressions supérieures, le plasma est alors essentiellement produit sur la face arrière de l'aimant 3, et non face avant, côté utilisation. La technique de production de plasma reste donc limité au domaine des basses pressions ;

3) dans le cas d'une source de plasma non plane (réacteur cylindrique), le fait de mettre les aimants permanents à distance des parois réduit le volume utile de plasma dans le réacteur.

Comme le montre la Fig. 2, FR 2 840 451 divulgue quant à lui une source de plasma 10 plane où les micro-ondes sont appliquées au plasma par des applicateurs 9 de propagation coaxiaux se terminant selon une section droite. Ces applicateurs 9 étant généralement distribués selon un réseau carré, ces types de plasma 10 sont appelés des plasmas matriciels. A priori, le domaine de pression visé (10 à $10^3$ pascal) ne requiert pas de champ magnétique, mais FR 2 840 451 enseigne la possibilité de disposer un aimant 3 dans l'âme centrale 11 de l'applicateur. Dans ce cas, les lignes 5 de champ magnétique se re-bouclent nécessairement sur des parois 1 métalliques ou diélectriques de l'enceinte. Dans ce cas, les électrons accélérés à la RCE sont tous collectés sur l'applicateur coaxial 9, ce qui est catastrophique sur le plan du bilan de puissance du plasma. Le confinement du plasma est inefficace, l'aimant 3 servant uniquement à fournir les conditions de RCE indispensables pour obtenir le claquage du plasma 10 aux basses pressions (de l'ordre de un pascal à quelques dizaines de pascal).

Pour ces raisons, WO2008/009559 a proposé de remédier à tous les inconvénients précédents.

A cet effet, la solution proposée par WO2008/009559 consisté à distribuer dans l'enceinte

- soit des aimants annulaires à aimantation radiale, disposés à la périphérie du plasma (confinement du plasma),

- soit des sources élémentaires dans lesquelles un aimant annulaire à aimantation radiale est placé à l'extrémité de la structure coaxiale d'amenée des micro-ondes.

La distribution des aimants ou des sources comportant les aimants s'effectue selon des réseaux bi- ou tri-dimensionnels, par exemple rectangulaires ou hexagonaux, comme le montrent les figures 3A et 3B.

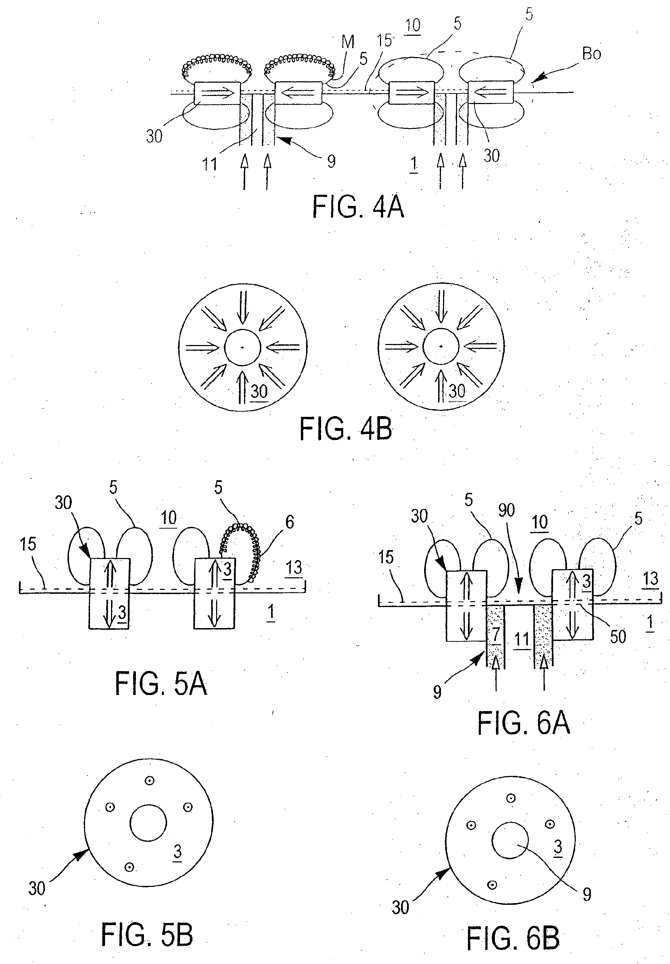

Seules les lignes 5 de champ magnétique à l'avant d'un plan 15 médian des aimants 30 sont situées côté plasma 10, comme le montrent par exemple les figures 4A et 4B.

Avec ce type de configuration magnétique, les lignes 5 de champ ne traversent jamais le plan médian 15 de l'aimant et les zones RCE entourent généralement l'aimant 30, ce qui permet de pallier l'ensemble des inconvénients décrits dans la critique de l'état de l'art, à savoir :

1) les lignes 5 de champ ne traversent aucune surface ou paroi 1 (la configuration des lignes 5 de champ de chaque aimant 30 permanent fait qu'elles vont d'un pôle au pôle opposé sans jamais traverser le plan médian 15 de l'aimant 30), et donc les électrons piégés autour de ces lignes 5 de champ restent bien confinés;

2) si l'aimant 30 présente une aimantation suffisante, les conditions de RCE sont vérifiées et les lignes 5 de champ sont situées sur la face avant de la structure coaxiale, d'où une production du plasma vers le volume utile face à l'applicateur;

3) le dispositif de WO2008/009559 permet une production de plasma dense dans un large domaine de pression (depuis $10^{-2}$ pascal jusqu'à $10^3$ pascal, avec un même applicateur 9 et avec une efficacité de couplage maximum),

- soit avec un couplage RCE (couplage résonnant),
- soit avec un couplage par absorption collisionnelle lorsque le champ magnétique devient inopérant, c'est-à-dire lorsque la fréquence $\nu$ de collisions élastiques des électrons devient grande devant la pulsation du champ électrique micro-onde, égale, à la RCE, à la pulsation électronique cyclotronique $\omega c$ ($\nu \gg \omega c$).

Ainsi, le champ magnétique ne perturbe pas le couplage par absorption collisionnelle, qui prend le relais de la RCE lorsque la pression augmente.

WO2008/009559 permet l'extension d'échelle du confinement et de la production de plasma. En effet, il n'y a pas de limitation théorique, voire technologique, à augmenter le nombre d'applicateurs, soit sur une surface plane, soit sur une surface non plane, par exemple cylindrique.

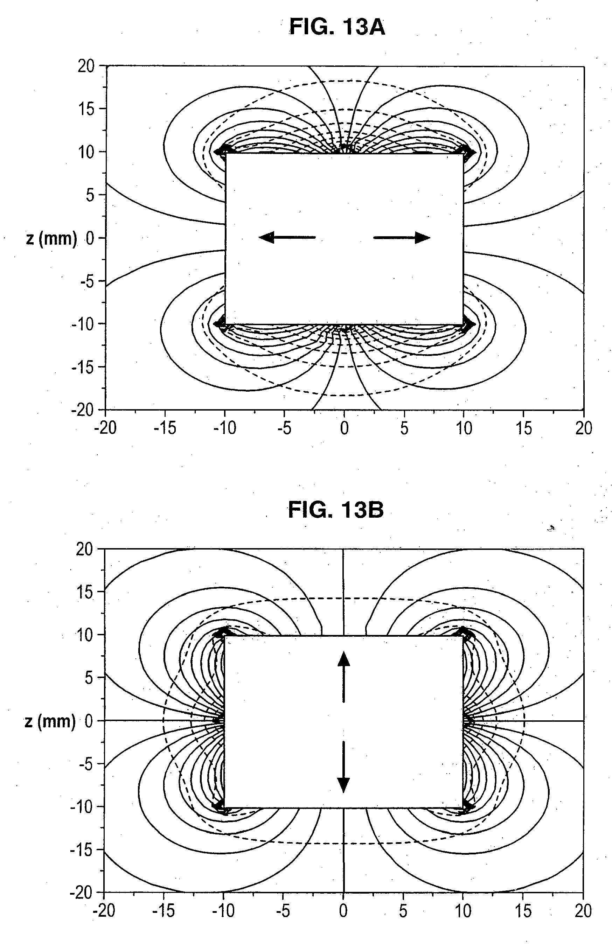

La figure 13A montre les lignes iso-B (traits pointillés) et les lignes de champ (traits pleins) pour des aimants à aimantation radiale pour des structures cylindriques (rayon R = 10 mm, hauteur Z = 20 mm) en SmCo.

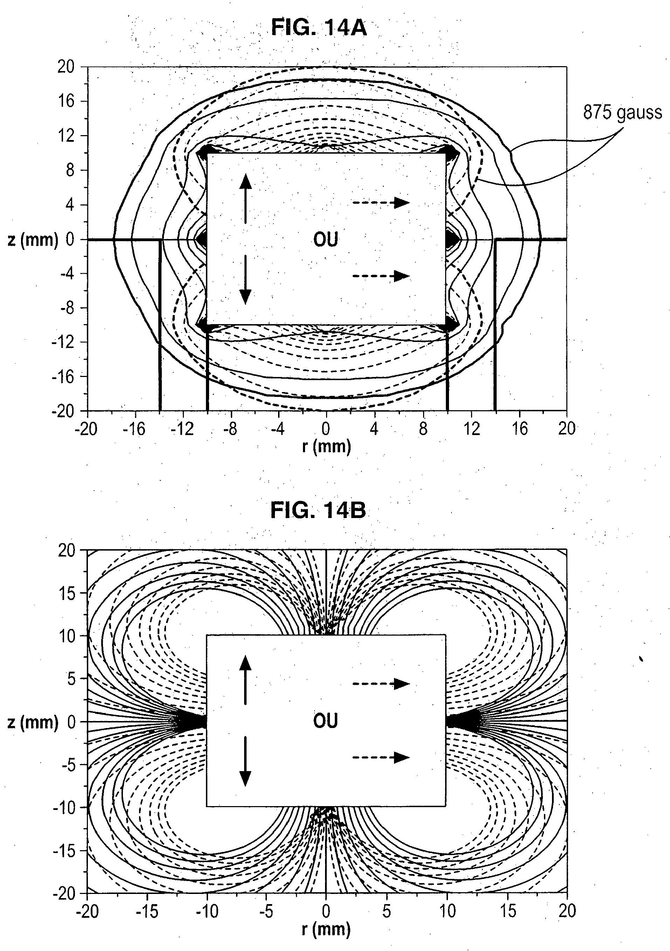

Les lignes iso-B sont reprises sur la figure 14A (traits pointillés) et les lignes de champ sont reprises sur la figure 14B (traits pointillés).

En revanche, le dispositif de WO2008/009559 présente également des inconvénients. Les aimants à aimantation radiale sont difficiles à trouver dans le commerce, car de réalisation difficile, surtout si les dimensions des aimants sont faibles, en particulier au niveau du diamètre intérieur de l'aimant.

Le dispositif de WO2008/009559 comporte des structures magnétiques composites associant différents types d'aimantation. Or la réalisation de structures magnétiques composites associant différents types d'aimantation diminue la compacité de chaque source. En outre, de telles structures composites peuvent s'avérer très difficile, voire impossible à réaliser techniquement. Par exemple dans le cas d'une structure radiale, la réalisation d'une structure cylindrique telle que représentée sur la Fig. 13A requiert l'assemblage par collage de plusieurs secteurs, d'où la très grande difficulté, voire l'impossibilité de réaliser certaines structures très compactes ou composites.

Un inconvénient majeur des structures à aimantation radiale (cf. Fig. 13A) est que les lignes de même intensité de champ magnétique (lignes iso-B) sont situées préférentiellement de part et d'autre des faces opposées de la structure magnétique radiale. Dans ce cas, une part importante de la puissance micro-onde en sortie d'applicateur (Fig. 14A) peut rayonner hors de l'applicateur sans rencontrer les conditions de résonance cyclotronique électronique (RCE), d'où un couplage non optimisé des micro-ondes au plasma.

On connait de plus de WO2008/009558 un dispositif de production et de confinement d'un plasma dans un volume. Dans le dispositif de WO2008/009558 la configuration magnétique comporte impérativement au moins une paire d'aimants permanents concentriques à aimantation axiale, aimants dont les aimantations sont impérativement alternées. La diminution des pertes dans le plasma n'est donc pas optimale, car certaines lignes de champ joignent les pôles opposés des deux aimants concentriques ou d'un même aimant.

PRESENTATION DE L'INVENTION

L'invention a pour but de résoudre au moins un des inconvénients précités.

A cet effet, on propose selon l'invention un dispositif selon la revendication 1.

L'invention est avantageusement complétée par les caractéristiques des revendications 2 à 9.

L'invention concerne également un procédé de production et/ou de confinement d'un plasma dans un dispositif précité.

L'invention présente de nombreux avantages.

Du fait que l'ensemble magnétique est composé d'aimants uniquement de direction d'aimantation axiale, la structure magnétique à aimant permanent est de réalisation beaucoup plus simple, tout en étant capable de produire des configurations magnétiques dans lesquelles les lignes de champ ne traversent jamais le plan médian de l'aimant ni les parois de l'enceinte.

L'invention permet un confinement de plasmas denses de grandes dimensions, depuis les plus basses pressions ($10^{-2}$ pascal ou moins) jusqu'à la dizaine de pascal (pression à laquelle le confinement magnétique devient inefficace). On peut ainsi opérer dans un large domaine de pression, soit avec un couplage RCE, soit avec un couplage par absorption collisionnelle lorsque le champ magnétique devient inopérant, c'est-à-dire lorsque la fréquence $\nu$ de collisions élastiques des électrons devient grande devant la pulsation $\omega_0 = 2\pi f_0$ du champ électrique micro-onde ($\nu \gg \omega_0$), égale, à la RCE, à la pulsation électronique cyclotronique $\omega_c$ ($\omega_0 = \omega_c$).

L'invention proposée peut trouver des applications très nombreuses, en particulier dans le domaine des traitements de surface, comme la gravure, les dépôts (PACVD ou PAPVD), l'implantation ionique par immersion plasma, pour ne citer que quelques exemples. On peut également citer l'application de l'invention à l'éclairage. En ce qui concerne l'application à l'éclairage, l'invention apporte des avantages importants par rapport aux dispositifs actuels connus. En effet, les plasmas produits selon l'invention peuvent être produits avec des puissances très faibles (de l'ordre du W), sans retard à l'allumage (allumage immédiat), et sans rayonnement micro-onde (absorption totale des micro-ondes), autant d'avantages par rapport aux lampes basse consommation actuelles utilisant des fréquences RF beaucoup plus basses.

L'invention permet la production de plasma dans le domaine de pression allant de $10^{-3}$ à quelques $10^3$ pascal, c'est-à-dire de l'ordre de $10^{-5}$ à 10 torr (1 torr = 133 pascal) en vue d'applications :

- aux traitements de surfaces (nettoyage, stérilisation, gravure, dépôt, implantation ionique, etc.),
- à la production d'espèces nouvelles (atomes, radicaux, métastables, espèces chargées, photons),
- à la réalisation de sources d'ions pour toute application nécessitant des faisceaux d'ions (sources d'ions mono- ou multi-chargés), ainsi que
- à tout domaine nécessitant la production, sur de grandes surfaces ou de grands volumes, de plasma uniforme.

Un autre avantage apporté par l'invention est la possibilité de réaliser une structure de confinement où les lignes de champ magnétique sont toutes situées dans le même demi-espace, d'où un confinement idéal du plasma dans le domaine des basses pressions.

En effet, avec ce type de configuration magnétique, les lignes de champ ne traversent jamais le plan médian de l'aimant et les zones RCE entourent généralement l'aimant, ce qui permet de pallier les inconvénients de l'état de l'art, à savoir :

1) les lignes de champ ne traversent aucune surface ou paroi, et donc les électrons piégés autour de ces lignes de champ restent bien confinés;
2) si l'aimant présente une aimantation suffisante, les conditions de RCE et les lignes de champ sont situées sur la face avant de la structure coaxiale, d'où une production du plasma vers le volume utile.

Il n'y a de plus aucune diminution du volume utile de plasma dans le réacteur, car le dispositif ne comporte avantageusement pas de tiges supportant les aimants vers l'intérieur de l'enceinte.

Un autre avantage apporté par l'invention est l'extension d'échelle du confinement et de la production de plasma. En effet, il n'y a pas de limitation théorique, voire technologique, à augmenter le nombre d'applicateurs, soit sur une surface plane, soit sur une surface non plane, par exemple cylindrique. Il est possible d'alimenter en puissance micro-onde autant d'applicateurs que souhaités par autant de générateurs indépendants que nécessaires, avec ou sans division de puissance. Chaque applicateur peut être alimenté à l'aide d'un câble coaxial puisque la puissance micro-onde nécessaire à chaque applicateur est relativement faible, d'où la grande fiabilité du dispositif global.

Un autre avantage est la possibilité de produire des plasmas denses dans toute la gamme de pression définie dans l'invention, depuis $10^{-2}$ pascal jusqu'à $10^3$ pascal avec le même applicateur, et avec une efficacité de couplage maximum. En effet, grâce à l'invention, il est possible d'entretenir le plasma aussi bien dans le régime de RCE (couplage résonnant) que dans le domaine hors RCE, à plus haute pression (couplage par absorption collisionnelle).

Un autre avantage est que, pour des aimants du commerce et des conditions opératoires conventionnelles (par exemple, une fréquence micro-onde $f_0 = 2{,}45$ GHz), les lignes d'intensité de champ magnétiques $B_0$ entourent complètement chaque aimant de telle sorte que les micro-ondes ne peuvent pas rayonner en dehors de la zone de l'applicateur sans traverser une zone de couplage RCE, d'où un couplage optimum des micro-ondes avec un plasma à basse et très basse pression.

Pour la RCE, il est possible d'utiliser des fréquences micro-ondes (5,8 GHz, 2,45 GHz, 920 MHz), mais aussi des fréquences plus basses (jusqu'à la centaine de MHz).

Pour chaque source élémentaire, on peut prévoir des alimentations unitaires par transistors de puissance, y compris à 2,45 GHz, voire 5,8GHz.

La figure 13B montre les lignes iso-B (traits pointillés) et les lignes de champ (traits pleins) pour des aimants à aimantation axiale tête-bêche (c'est-à-dire que l'ensemble est sensiblement symétrique par rapport à l'enveloppe) selon l'invention pour des structures cylindriques (rayon R = 10 mm, hauteur Z = 20 mm) en SmCo.

Les lignes iso-B sont reprises sur la figure 14A (traits pleins) et les lignes de champs sont reprises sur la figure 14B (traits pleins). La Fig. 14A indique les conditions de RCE pour des micro-ondes à 2,45 GHz (875 gauss ou 0,0875 tesla) pour la structure à aimantation radiale (ligne en pointillés) et celle à aimantation axiale tête-bêche (ligne en traits pleins) pour des structures magnétiques en samarium cobalt de mêmes dimensions (hauteur Z = 20 mm, rayon R = 10 mm).

Un autre avantage est que les structures magnétiques selon l'invention sont très compactes. En effet, pour obtenir des densités très élevées à partir de sources de plasma de très grandes dimensions, il est nécessaire de pouvoir assembler sur une surface donnée le plus grand nombre d'applicateurs par unité de surface, afin de pouvoir coupler au plasma la plus grande densité de puissance micro-onde par unité de surface. Aussi, la réalisation de structures magnétiques ayant un seul type d'aimantation augmente la compacité de chaque source et assure la possibilité de sa réalisation technique.

Un autre avantage est ainsi la facilité de réalisation d'une structure magnétique selon l'invention. Dans l'invention, la réalisation d'une structure tête-bêche (c'est-à-dire symétrique par rapport à l'enveloppe) est très aisée puis qu'il suffit de coller deux aimants d'aimantations opposées (voir Fig. 13B).

Un autre avantage concerne la configuration magnétique générée par la structure magnétique. Dans l'invention, bien que les lignes de champ aient une allure similaire dans les deux cas (aimantation radiale et aimantation axiale tête-bêche) comme indiqué sur la Fig 14B, les lignes de même intensité de champ magnétique (lignes iso-B) entourent complètement la structure magnétique (Figs. 13B et 14A). Dans ce cas, la puissance micro-onde en sortie d'applicateur (Fig. 14A) ne peut rayonner hors de l'applicateur sans rencontrer les conditions RCE, d'où un couplage parfaitement optimisé des micro-ondes au plasma.

PRESENTATION DES FIGURES

D'autres caractéristiques, buts et avantages de l'invention ressortiront de la description qui suit, qui est purement illustrative et non limitative, et qui doit être lue en regard des dessins annexés sur lesquels :

les figures 1 et 2, déjà commentées, représentent schématiquement des montages selon l'art antérieur;

les figures 3A et 3B représentent schématiquement deux exemples possibles de réseaux bi-dimensionnels;

les figures 4A et 4B représentent schématiquement respectivement une vue en coupe et une vue de face d'un mode de réalisation connu;

les figures 5A et 5B représentent schématiquement respectivement une vue en coupe et une vue de face d'un premier mode de réalisation possible de l'invention;

les figures 6A et 6B représentent schématiquement respectivement une vue en coupe et une vue de face d'un deuxième mode de réalisation possible de l'invention ;

les figures 7A et 7B représentent schématiquement respectivement une vue en coupe et une vue de face d'un troisième mode de réalisation possible de l'invention ;

les figures 8A et 8B représentent schématiquement respectivement une vue en coupe et une vue de face d'un quatrième mode de réalisation possible de l'invention ;

les figures 9A et 9B représentent schématiquement respectivement une vue en coupe et une vue de face d'un cinquième mode de réalisation possible de l'invention ;

les figures 10A et 10B représentent schématiquement respectivement une vue en coupe et une vue de face d'un sixième mode de réalisation possible de l'invention ;

la figure 11 représentent schématiquement respectivement une vue en coupe d'un septième mode de réalisation possible de l'invention ;

les figures 12A à 12C représentent schématiquement des coupes de modes de réalisation possibles d'un applicateur selon l'invention ;

les figures 13A et 13B représentent schématiquement des lignes de champ (traits pleins) et iso-B (traits pointillés) respectivement pour une structure magnétique à aimantation radiale et pour une structure magnétique à aimantation axiale tête-bêche (symétrique par rapport à l'enveloppe) ;

la Fig. 14A représente les lignes iso-B pour les conditions de RCE pour des micro-ondes à 2,45 GHz (875 gauss ou 0,0875 tesla) pour la structure à aimantation radiale (ligne en pointillés) et celle à aimantation axiale tête-bêche (ligne en traits pleins) pour des structures magnétiques en samarium cobalt (aimantation identique) de mêmes dimensions (hauteur Z = 20 mm, rayon R = 10 mm) ; et

la Fig. 14B représente les lignes de champ pour les conditions de RCE pour des micro-ondes à 2,45 GHz (875 gauss ou 0,0875 tesla) pour la structure à aimantation radiale (ligne en pointillés) et celle à aimantation axiale tête-bêche (ligne en traits pleins) pour des structures magnétiques en samarium cobalt (aimantation identique) de mêmes dimensions (hauteur Z = 20 mm, rayon R = 10 mm)

Dans toutes les figures, les éléments similaires portent des références numériques identiques.

DESCRIPTION DETAILLEE

Afin de conférer à une structure magnétique multipolaire une grande efficacité de confinement et/ou de production pour les plasmas, on propose selon l'invention de faire en sorte que les trajectoires des particules chargées issues du plasma et piégées autour d'une ligne de champ magnétique ne rencontrent pas de parois (pertes par le mécanisme 3).

Pour cela, il faut que les trajectoires des électrons piégés soient libres de tout obstacle entre deux points miroir M d'égale intensité de champ magnétique.

On propose ainsi selon l'invention un dispositif de production et/ou de confinement d'un plasma 10, visible plus particulièrement aux figures 5A à 12C.

Comme le montrent les figures 5A, 6A, 7A, 8A, 9A, 10A et 11 par exemple, le dispositif comporte principalement une enceinte 13 dans le volume de laquelle le plasma 10 est produit ou confiné.

L'enceinte 13 comprend une paroi 1 définissant une enveloppe 15 intérieure à l'enceinte et englobant le volume.

Dans la suite de la présente description, on appelle « enceinte » le récipient dans le volume duquel le plasma 10 est produit ou confiné, un même dispositif pouvant ainsi être divisé en plusieurs enceintes, par exemple par des cloisons internes ou des parois supplémentaires séparant le dispositif.

L'enveloppe correspond à la surface de la paroi 1 interne à l'enceinte 13.

Le dispositif comporte au moins un ensemble 30 de production et/ou de confinement du plasma.

Chaque ensemble 30 est composé d'aimants 3 uniquement de direction d'aimantation axiale arrangés par rapport à l'enveloppe 15, de sorte que la direction d'aimantation de tous les aimants 3 composant chaque ensemble 30 soit sensiblement perpendiculaire à l'enveloppe 15.

De plus, chaque ensemble 30 est enfoncé dans la paroi 1 définissant l'enveloppe 15, et les aimants 3 sont arrangés entre eux de sorte que l'ensemble 30 soit sensiblement symétrique par rapport à l'enveloppe 15.

Avec cette configuration, les lignes 5 de champ magnétique ne traversent pas la paroi 1 de l'enceinte.

On comprend que si l'ensemble 30 n'est pas parfaitement symétrique par rapport à l'enveloppe 15, c'est-à-dire que l'ensemble 30 est légèrement trop enfoncé dans la paroi, ou légèrement trop peu enfoncé dans la paroi, le dispositif selon l'invention fonctionne aussi, mais avec un rendement plus faible, étant donné que certaines lignes de champ traversent la paroi de l'enceinte et que des électrons seront perdus pour le plasma 10.

Les figures 5A et 5B montrent schématiquement que l'ensemble 30 comporte deux aimants 3 annulaires symétriques par rapport à l'enveloppe 15.

Une telle configuration de l'ensemble 30 permet de réaliser un confinement du plasma, sans que les trajectoires 6 des électrons piégés ne rencontrent une paroi 1 de l'enceinte.

D'une façon générale, chaque aimant 3 annulaire comporte principalement une aimantation axiale, et l'ensemble 30 présente une symétrie par rapport à un plan perpendiculaire à la direction d'aimantation axiale, que l'on pourra appeler un plan 50 médian de l'ensemble 30. Pour un meilleur rendement, on fait coïncider le plan 50 et l'enveloppe 15 lors du montage de l'ensemble 30 dans la paroi 1.

Comme le montrent les figures 6A et 6B, pour réaliser une production de plasma 10, l'ensemble 30 peut comporter en outre au moins une source élémentaire de plasma comportant un applicateur coaxial 9 de micro-ondes.

L'applicateur 9 traverse la paroi 1 de l'enceinte et comprend une âme centrale 11.

Chaque aimant annulaire 3 est centré sur l'âme centrale 11 de l'applicateur 9. Les aimants annulaires 30 à aimantation axiale sont placés autour d'une extrémité libre 90 de l'applicateur coaxial d'amenée des micro-ondes et sont enfoncés dans la paroi 1 de l'enceinte en périphérie externe de l'applicateur 9.

Dans le cas de confinement et/ou de production, seules les lignes de champ magnétique 5, à l'avant du plan longitudinal médian 50 de l'ensemble 30, sont situées côté plasma 10, comme le montrent les Fig. 5A et 6A.

Le dispositif des Fig. 6A et 6B notamment permet de résoudre les difficultés de l'art antérieur.

En effet, le plasma est confiné de manière efficace. Il peut être produit face à l'applicateur 9. De plus, le champ magnétique $B_0$ ne perturbe pas le couplage par absorption collisionnelle, qui prend le relais de la RCE lorsque la pression augmente. En effet, la configuration des lignes 5 de champ de l'ensemble 30 font que ces dernières vont d'un pôle au pôle opposé sans jamais traverser le plan médian 50 de l'ensemble 30.

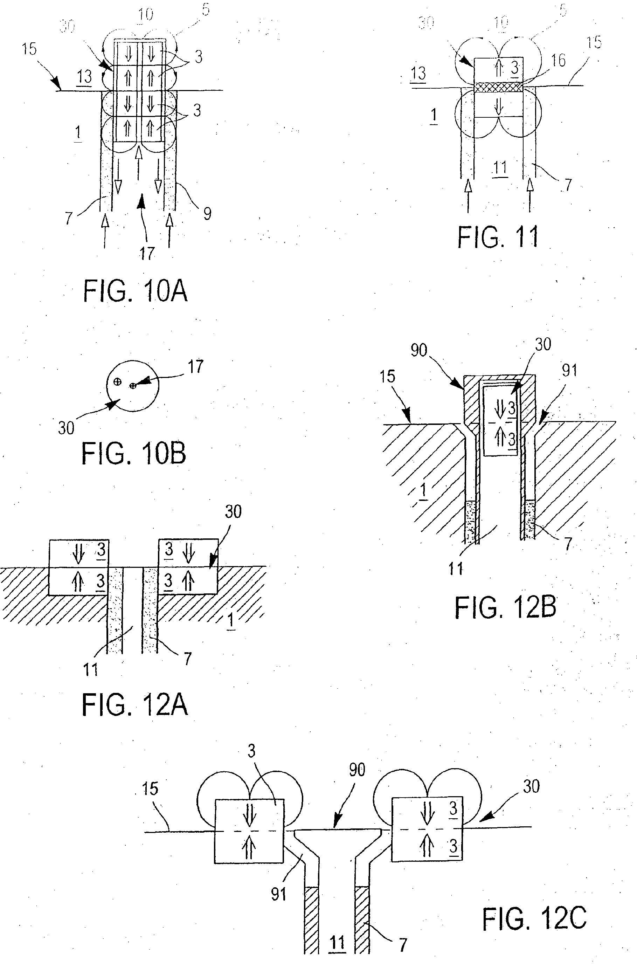

L'applicateur coaxial 9 comporte préférentiellement un matériau diélectrique 7 disposé autour de l'âme centrale 11, au niveau de la paroi 1 de l'enceinte (voir également figure 12A). Le matériau diélectrique 7 peut être disposé au dessous du niveau de la paroi (voir figures 12B et 12C).

L'extrémité libre 90 de l'applicateur peut avoir plusieurs formes possibles. A titre d'exemple non limitatif, l'extrémité libre 90 peut avoir une section droite plus importante que la section droite de l'âme centrale 11 (voir figures 12B et 12C). L'applicateur comporte alors préférentiellement des chicanes 91 pratiquées dans la paroi 1, de sorte d'une part que l'espace entre l'âme centrale 11 et la paroi soit sensiblement toujours identique et d'autre part pour éviter une métallisation du matériau diélectrique 7 dans les applications du dispositif à la pulvérisation de métaux (le matériau 7 est protégé par l'extrémité libre 90).

Dans le cas de la figure 12C, le diamètre interne de l'ensemble 30 est supérieur au diamètre externe de l'extrémité libre 90.

Dans le cas de la figure 12B, l'extrémité libre 90 est située au-dessus de la paroi 1. Elle peut alors recouvrir l'ensemble 30, par exemple située à l'intérieur de l'âme centrale 11, mais toujours de sorte à être symétrique par rapport à l'enveloppe 15.

Le matériau 7 est préférentiellement disposé sur une partie au moins de la longueur de l'applicateur 9.

Le matériau diélectrique peut aussi être formé par le vide à basse et très basse pression (ce qui correspond aux conditions de fonctionnement du dispositif).

Un dispositif selon l'invention, pour réaliser un dispositif de confinement d'un plasma 10 de grandes dimensions, comporte, selon des réseaux bi- ou tri-dimensionnels, une pluralité d'ensembles 30 à aimantation axiale, disposés à la périphérie du plasma 10. Plus le réseau d'ensembles 30 est dense, plus le plasma est dense et localisé vers le centre du volume de l'enceinte.

Le dispositif peut également comporter une pluralité d'ensembles 30 comportant chacune un applicateur 9.

Chaque réseau bi ou tri dimensionnel est par exemple rectangulaire ou carré, comme le montre la figure 3A, ou hexagonal, comme le montre la Fig. 3B.

Ainsi, pour des ensembles distribués selon des réseaux bi- ou tridimensionnels, le dispositif présente une structure magnétique :

- d'une part générant, par RCE (c'est-à-dire capable de délivrer le champ magnétique d'intensité $B_0$ nécessaire au couplage RCE), un plasma 10 essentiellement dans la direction face aux applicateurs 9, et,
- d'autre part permettant, suivant la forme de l'extrémité libre 90 de l'applicateur 9, un fonctionnement dans un large domaine de pressions, soit par couplage RCE du champ électrique micro-onde avec les électrons (couplage résonnant), soit, à plus haute pression, par couplage par absorption collisionnelle, lorsque le champ magnétique devient inopérant.

Chaque ensemble peut présenter une polarité quelconque au plasma, mais les ensembles 30 distribués suivant des réseaux bi- ou tridimensionnels présentent au plasma 10 préférentiellement tous le même sens d'aimantation axiale, par rapport aux parois 1 ou aux applicateurs 9 qu'ils entourent, pour éviter que des lignes de champ magnétique d'un ensemble ne se rebouclent sur le pôle opposé d'un autre ensemble en traversant le plan médian 50 de l'ensemble, et par voie de conséquence en traversant une paroi 1 de l'enceinte.

Seule une partie des ensembles 30 (un ensemble 30 sur deux, ou une rangée sur deux d'ensembles 30, à titre d'exemples non limitatifs) peuvent être alimentés en micro-ondes par un applicateur 9.

L'invention peut présenter de nombreuses variantes par rapport aux configurations proposées sur les Figs. 5A à 6B. Ces variantes concernent notamment la position de l'ensemble 30 par rapport à l'applicateur coaxial 9, et/ou la forme de l'extrémité libre 90 de l'applicateur (fig. 12).

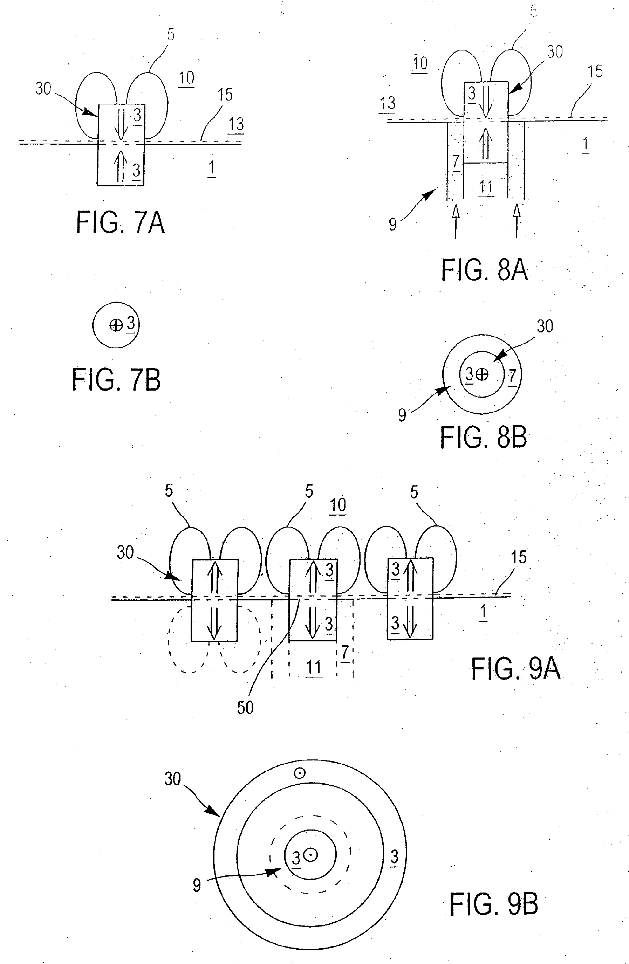

Les figures 7A et 7B montrent que l'ensemble 30 de confinement peut être composé d'un barreau comportant deux aimants 3 à aimantation axiale, enfoncé dans la paroi 1 de l'enceinte et arrangé pour être symétrique par rapport à l'enveloppe 15 (à noter que dans ce cas, l'ensemble 30 présente au plasma une polarité opposée à celle présentée au plasma dans les figures 5 et 6 par exemple, ce qui, on le rappelle, n'a pas d'importance pour un dispositif comportant un seul ensemble).

Les figures 8A et 8B montrent que l'ensemble 30 selon les figures 7A et 7B peut comporter en outre un applicateur 9, les aimants 3 de direction d'aimantation axiale pouvant alors être enfoncés dans l'âme centrale 11 d'un applicateur 9.

Les figures 9A et 9B montrent que chaque ensemble 30 peut comporter deux aimants circulaires 3 symétriques par apport à l'enveloppe 15, centrés autour de deux aimants 3 sous forme de barreaux, eux aussi symétriques par rapport à l'enveloppe 15.

Comme on peut le constater sur les figures 9A et 9B, les aimants 3 présentent au plasma 10 préférentiellement tous le même sens d'aimantation axiale par rapport aux parois 1, pour éviter que des lignes de champ magnétique d'un aimant 3 ne se rebouclent sur le pôle opposé d'un autre aimant 3 en traversant le plan médian 50 de l'ensemble. Les traits pointillés montrent que l'applicateur 9 est optionnel dans l'ensemble 30, en fonction des applications choisies.

Les figures 10A et 10B montrent qu'on peut superposer des aimants 3 sur d'autres aimants 3 de l'ensemble 30, à condition que l'ensemble 30 reste symétrique par rapport à l'enveloppe 15.

La figure 11 montre qu'on peut interposer un élément 16 à forte perméabilité magnétique (par exemple un bloc de fer doux) ou à faible perméabilité magnétique relative (par exemple égale à 1) entre les deux aimants 3 de l'ensemble 30, à condition que l'ensemble 30 reste symétrique par rapport à l'enveloppe 15.

L'élément 16 permet de conditionner les lignes de champ, et de les éloigner des parois de l'enceinte.

Ces variantes, présentées à titre d'exemples non limitatifs, permettent l'optimisation des sources de plasma élémentaires en fonction de l'application ou du procédé visés (simple confinement du plasma ou confinement et production de plasma, domaine de pression utile, etc.). En particulier, pour éviter, dans certaines conditions opératoires, le couplage du plasma dans la structure coaxiale, il est souvent préférable, comme on l'a vu, d'utiliser un applicateur rempli totalement ou partiellement de matériau diélectrique 7.

Les aimants 3 annulaires des ensembles 30 peuvent aussi présenter des formes variées : circulaire, polygonale (carrée, hexagonale, octogonale, décagonale...). Mais la forme annulaire circulaire est de loin la plus commune et la plus simple à mettre en oeuvre.

De même le barreau de la figure 7 est préférentiellement de symétrie de révolution, mais peut avoir d'autres géométries.

Bien entendu, le confinement et la production de plasmas très denses (au-delà de $10^{10}$ cm$^{-3}$) nécessitent le refroidissement des structures magnétiques et coaxiales, par exemple par une circulation 17 d'un fluide caloporteur gazeux ou liquide (comme représenté à la figure 10 par exemple).

Avec la technologie décrite, il est possible de réaliser soit des sources planes de grandes dimensions, soit des sources et/ou enceintes cylindriques ou sphériques, suivant l'application visée.

La fréquence micro-onde utilisée n'est pas critique, et il est donc possible d'utiliser l'une des fréquences ISM comme le 915 MHz ou le 2,45 GHz, voire 5.8 GHz. Pour une excitation du plasma à la résonance cyclotronique électronique par des micro-ondes à 2,45 GHz, la condition de résonance ($B_0=0,0875$ tesla) est facilement remplie par des aimants permanents conventionnels, comme en samarium-cobalt, voire en ferrite de baryum ou en ferrite de strontium. C'est encore plus le cas à 100, 200 ou 300 MHz, où le coût des transistors de puissance est bien plus faible qu'à 915 MHz ou 2,45 GHz. Les fréquences données à titre d'exemple ne sont bien entendu pas limitatives.

**Revendications**

1. Dispositif de production et/ou de confinement d'un plasma (10), comportant une enceinte (13) dans le volume de laquelle le plasma est produit et/ou confiné, ladite enceinte (13) comprenant une paroi (1) définissant une enveloppe (15) intérieure à l'enceinte et englobant le volume,
ledit dispositif comporte ultérieurement

   - au moins un ensemble (30) de production et/ou de confinement du plasma, chaque ensemble (30) étant

   composé d'aimants (3) uniquement de direction d'aimantation axiale, et
   enfoncé dans la paroi (1) définissant l'enveloppe, de sorte que la direction d'aimantation de tous les aimants (3) composant chaque ensemble (30) soit sensiblement perpendiculaire à l'enveloppe (15) définie par la paroi (1) le dit dispositif étant **caractérisé en ce que** l'ensemble (30) est sensiblement symétrique par rapport à l'enveloppe, les lignes (5) de champ magnétique ne traversant pas la paroi (1) de l'enceinte.

2. Dispositif selon la revendication 1, comportant une pluralité d'ensembles (30) arrangés dans la paroi (1) pour former un réseau bi-dimensionnel ou tri-dimensionnel.

3. Dispositif selon la revendication 2, dans lequel le réseau est carré ou hexagonal.

4. Dispositif selon l'une des revendications 1 à 3, dans lequel au moins un ensemble (30) comporte en outre au moins une source élémentaire de plasma comportant un applicateur coaxial (9) de micro-ondes comprenant une âme centrale (11), l'applicateur (9) traversant la paroi (1) de l'enceinte.

5. Dispositif selon la revendication 4, dans lequel l'ensemble (30) comporte des aimants (3) de direction d'aimantation axiale enfoncés dans l'âme centrale (11) de l'applicateur.

6. Dispositif selon l'une des revendications 4 ou 5, dans lequel l'ensemble (30) comporte des aimants de direction d'aimantation axiale enfoncés dans la paroi de l'enceinte en périphérie externe de l'applicateur (9).

7. Dispositif selon l'une des revendications 1 à 6, dans lequel l'ensemble (30) comporte un élément (16) en fer doux ou à perméabilité magnétique relative égale à 1.

8. Dispositif selon l'une des revendications 4 à 7, dans lequel l'applicateur coaxial comporte un matériau diélectrique (7) disposé autour de l'âme centrale (11), au moins sur une partie de la longueur de l'applicateur, ou comporte du vide à basse et très basse pression.

9. Dispositif selon l'une des revendications 4 à 8, dans lequel chaque aimant (3) délivre un champ magnétique d'amplitude $B_0$ qui vérifie la relation

$$f_0 = eB_0/2\pi m_e$$

où : $f_0$ est la fréquence du champ électrique micro-onde appliqué par l'applicateur coaxial (9), e est la charge électronique, et $m_e$ est la masse de l'électron,

pour permettre la production du plasma à basse pression par résonance cyclotronique électronique.

10. Procédé de production et/ou de confinement d'un plasma (10) dans une enceinte (13), enceinte (13) dans le volume de laquelle le plasma est produit et/ou confiné, ladite enceinte (13) comprenant une paroi (1) définissant une enveloppe (15) intérieure à l'enceinte et englobant le volume,
ledit procédé étant **caractérisé en ce qu'**il comporte une étape selon laquelle on fournit au moins un ensemble (30) de production et/ou de confinement du plasma, chaque ensemble (30) étant composé d'aimants uniquement de direction d'aimantation axiale, et enfoncé dans la paroi (1) définissant l'enveloppe, de sorte que la direction d'aimantation de tous les aimants composant chaque ensemble (30) soit sensiblement perpendiculaire à l'enveloppe et que l'ensemble (30) soit sensiblement symétrique par rapport à l'enveloppe définie par la paroi (1), les lignes de champ magnétique traversant ainsi au minimum la paroi (1) de l'enceinte.

**Patentansprüche**

1. Vorrichtung zum Erzeugen und/ oder Abschotten eines Plasmas (10), einen abgeschlossenen Raum (13) umfassend, in dessen Volumen das Plasma erzeugt und/ oder abgeschottet wird, wobei der besagte abgeschlossene Raum (13) eine Wand (1) umfasst, die eine Hülle (15) innerhalb des abgeschlossenen Raums definiert und das Volumen enthält, wobei die besagte Vorrichtung darüber hinaus Folgendes umfasst

   - zumindest eine Einheit (30) zum Erzeugen und/ oder Abschotten des Plasmas, wobei jede Einheit (30)

   aus Magneten (3) nur mit axialer Magnetisierungsrichtung besteht, und in die Wand (1) eingedrückt ist, welche die Hülle definiert, sodass die Magnetisierungsrichtung aller Magneten (3), aus denen jede Einheit (30) besteht, in etwa senkrecht zur Hülle (15) verläuft, die von der Wand (1) definiert wird, wobei die besagte Vorrichtung **dadurch gekennzeichnet ist, dass** die Einheit (30) in etwa symmetrisch im Verhältnis zur Hülle verläuft, wobei die Magnetfeldlinien (5) nicht durch die Wand (1) des abgeschlossenen Raums führen.

2. Vorrichtung nach Anspruch 1, eine Vielzahl von Einheiten (30) umfassend, die in der Wand (1) angeordnet sind, um ein zweidimensionales oder dreidimensionales Netz zu bilden.

3. Vorrichtung nach Anspruch 2, wobei das Netz quadratisch oder hexagonal ist.

4. Vorrichtung nach einem der Ansprüche 1 bis 3, wobei zumindest eine Einheit (30) darüber hinaus zumindest eine elementare Plasmaquelle umfasst, die einen koaxialen Mikrowellenapplikator (9) umfasst, der einen zentralen Leiter (11) umfasst, wobei der Applikator (9) durch die Wand (1) des abgeschlossenen Raums führt.

5. Vorrichtung nach Anspruch 4, wobei die Einheit (30) Magneten (3) mit axialer Magnetisierungsrichtung umfasst, die in den zentralen Leiter (11) des Applikators eingedrückt sind.

6. Vorrichtung nach einem der Ansprüche 4 oder 5, wobei die Einheit (30) Magneten (3) mit axialer Magnetisierungsrichtung umfasst, die in die Wand des abgeschlossenen Raums an der äußeren Peripherie des Applikators (9) eingedrückt sind.

7. Vorrichtung nach einem der Ansprüche 1 bis 6, wobei die Einheit (30) ein Element (16) aus Weicheisen oder mit einer relativen magnetischen Permeabilität gleich 1 umfasst.

8. Vorrichtung nach einem der Ansprüche 4 bis 7, wobei der koaxiale Applikator ein dielektrisches Material (7) umfasst, das zumindet über einen Teil der Länge des Applikators um den zentralen Leiter (11) angeordnet ist, oder ein Vakuum mit niedrigem und sehr niedrigem Druck umfasst.

9. Vorrichtung nach einem der Ansprüche 4 bis 8, wobei jeder Magnet (3) ein Magnetfeld mit einer Amplitude $B_0$ abgibt, welches dem Verhältnis

$$f_0 = eB_0/2\pi m_e$$

genügt, wobei: $f_0$ die Frequenz des elektrischen Felds der Mikrowelle ist, das vom koaxialen Applikator (9) angewandt wird, e die elektronische Ladung, und $m_e$ die Masse des Elektrons ist, um das Erzeugen des Niederdruckplasmas durch elektronische Zyklotronresonanz zu ermöglichen.

10. Verfahren zum Erzeugen und/ oder Abschotten eines Plasmas (10) in einem abgeschlossenen Raum (13), einem abgeschlossenen Raum (13), in dessen Volumen das Plasma erzeugt und/ oder abgeschottet wird, wobei der besagte abgeschlossene Raum (13) eine Wand (1) umfasst, die eine Hülle (15) innerhalb des abgeschlossenen Raums definiert und das Volumen enthält, wobei das besagte Verfahren **dadurch gekennzeichnet ist, dass** es einen Schritt umfasst, bei dem man zumindest eine Einheit (30) zum Erzeugen und/ oder Abschotten des Plasmas bereitstellt, wobei jede Einheit (30) aus Magneten nur mit axialer Magnetisierungsrichtung besteht, und in die Wand (1) eingedrückt ist, die die Hülle definiert, sodass die Magnetisierungsrichtung aller Magneten (3), aus denen jede Einheit (30) besteht, in etwa senkrecht zur Hülle verläuft, und die Einheit (30) in etwa symmetrisch im Verhältnis zur Hülle verläuft, die von der Wand (1) definiert wird, wobei die Magnetfeldlinien somit minimal durch die Wand (1) des abgeschlossenen Raums führen.

## Claims

1. Device for producing and/or confining a plasma (10), comprising a chamber (13) in the space of which the plasma is produced and/or confined, said chamber (13) comprising a wall (1) defining a housing (15) internal to the chamber and encompassing the space,
   said device subsequently comprising

   - at least one assembly (30) for producing and/or confining plasma, each assembly (30) being

   composed of magnets (3) solely with an axial magnetisation direction, and
   recessed in the wall (1) defining the housing,
   so that the direction of magnetisation of all the magnets (3) making up each assembly (30) is substantially perpendicular to the housing (15) defined by the wall (1), said device being **characterised in that** the assembly (30) is substantially symmetrical with respect to the housing, the magnetic field lines (5) not passing through the wall (1) of the chamber.

2. Device according to claim 1, comprising a plurality of assemblies (30) arranged in the wall (1) in order to form a two-dimensional or three-dimensional array.

3. Device according to claim 2, in which the array is square or hexagonal.

4. Device according to one of claims 1 to 3, in which at least one assembly (30) also comprises at least one elementary plasma source comprising a coaxial microwave applicator (9) comprising a central core (11), the applicator (9) passing through the wall (1) of the chamber.

5. Device according to claim 4, in which the assembly (30) comprises magnets (3) with an axial magnetisation direction recessed in the central core (11) of the applicator.

6. Device according to one of claims 4 or 5, in which the assembly (30) comprises magnets with an axial magnetisation direction recessed in the wall of the chamber at the external periphery of the applicator (9).

7. Device according to one of claims 1 to 6, in which the assembly (30) comprises an element (16) made from soft iron or with a relative magnetic permeability equal to 1.

8. Device according to one of claims 4 to 7, in which the coaxial applicator comprises a dielectric material (7) disposed around the central core (11), at least over part of the length of the applicator, or comprises vacuum at low and very low pressure.

9. Device according to one of claims 4 to 8, in which each magnet (3) delivers a magnetic field of amplitude $B_0$ that satisfies the equation

$$f_0 = eB_0/2\pi m_e$$

   where: $f_0$ is the frequency of the microwave electrical field applied by the coaxial applicator (9),
   e is the electron charge, and
   $m_e$ is the mass of the electron,
   to enable plasma to be produced at low pressure by electron cyclotron resonance.

10. Method of producing and/or confining a plasma (10) in a chamber (13), a chamber (13) in the space of which the plasma is produced and/or confined, said chamber (13) comprising a wall (1) defining a housing (15) internal to the chamber and encompassing the space,
    said method being **characterised in that** it comprises a step according to which at least one plasma production and/or confinement assembly (30) is provided, each assembly (30) being
    composed of magnets solely with an axial magnetisation direction, and
    recessed in the wall (1) defining the housing,
    so that the magnetisation direction of all the magnets making up each assembly (30) is substantially perpendicular to the housing and so that the assembly (30) is substantially symmetrical with respect to the housing defined by the wall (1), the magnetic field lines thus passing through the wall (1) of the chamber to a minimum extent.

FIG. 1

FIG. 2

FIG. 3A

FIG. 3B

FIG. 4A

FIG. 4B

FIG. 5A

FIG. 6A

FIG. 5B

FIG. 6B

FIG. 7A

FIG. 7B

FIG. 8A

FIG. 8B

FIG. 9A

FIG. 9B

FIG. 10A

FIG. 10B

FIG. 11

FIG. 12A

FIG. 12B

FIG. 12C

## FIG. 13A

## FIG. 13B

## FIG. 14A

875 gauss

## FIG. 14B

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2797372
- FR 2838020
- FR 2840451
- WO 2008009559 A
- WO 2008009558 A